# EUROPEAN PATENT APPLICATION

(11) **EP 1 571 717 A2**
(43) Date of publication of application: **07.09.2005**
(21) Application number: 05003836.3
(22) Date of filing: 23.02.2005
(51) Int. Cl.: H01L 33/00

(54) **Light-emitting diode**

(30) Priority: 02.03.2004 JP 2004057143
(71) Applicant: Agilent Technologies Inc, Palo Alto, CA 94303-0870 (US)
(72) Inventor: Takekuma, Akira, Tama-Shi Tokyo 206-0013 (JP)
(74) Representative: von Kreisler Selting Werner

(57) **Abstract**

A light-emitting diode (10) having a first lead (20) with a cup (30) part in which a light-emitting element (50) is held, a second lead (40) in juxtaposition with the first lead (20), and a resin molding (60) enclosing the tips of first and second leads. Flag-shaped protrusions (22,42) are formed in the middle of first and second leads. The region from the cup part (30) of first lead (20) to flag-shaped protrusion (22) is relatively wide and continuous and concave parts (27,28) are formed along the side edges at a height near the bottom end of cup part of first lead.

## Description

### 1. Field of the Invention

The present invention pertains to a packaged light-emitting diode comprising light-emitting elements, and in particular, to a light-emitting diode comprising metal leads for holding the light-emitting elements.

### 2. Discussion of the Background Art

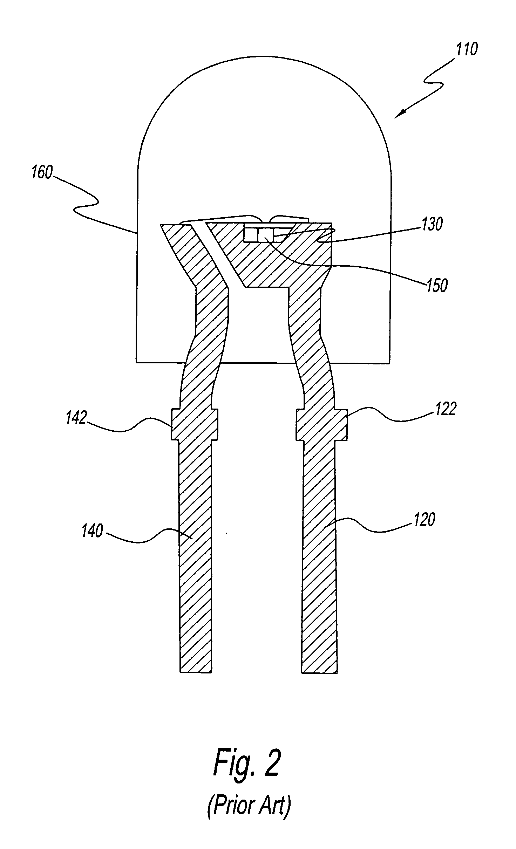

A conventional light-emitting diode has a structure wherein a light-emitting element is held on one lead of a pair of metal leads and the tips of the metal leads are enclosed by molding member that usually has the shape of a shell (refer to Patent References JP (Kokai) 10[1998]-190,065 and JP (Kokai) 2002-170,999). A typical example is shown in Figure 2. A light-emitting element 150 of a light-emitting diode 110 is placed inside a cup 130 formed in a lead 120 and a pair of leads 120 and 140 are electrically connected using wire bonding or other means. In another prior art design, which is not illustrated, a light-emitting element is connected to leads by a flip-chip packaging. Light-emitting element 150 is located near or at a position overlapping the center axis of molding member 160 enclosing the element when in a mounted state.

The metal leads are usually inserted in through holes in a substrate and are connected by soldering. For such use, the bottom ends of leads 120 and 140 are relatively narrow and extend down in a virtually straight line from molding member 160. In many cases, flag-shaped parts 122 and 142 laterally protruding to the side are formed slightly away from molded member 160 (refer to Patent References JP (Kokai) 10[1998]-190,065 and JP (Kokai) 2002-170,999). Flag-shaped parts 122 and 142 are formed when the lead frame is stamped or parts of the lead frame are cut.

According to the conventional structure of this type of light-emitting diode, the end part where the light-emitting element is located is relatively wide, but the part below it is narrow. Because the light-emitting element is a semiconductor device, heat is generated during operation. Consequently, in the conventional structure, the heat that is generated by the light-emitting element can not be smoothly escaped from the cup part. As a result, the temperature around the light-emitting element rises, and unexpectedly, there might be a reduction in the performances of the light-emitting element.

On the other hand, in order to allow the generated heat to escape, simple use of a wider lead has been considered, but there is a risk that thestrength for mechanically coupling with the outside molding member will not be obtained.

Therefore, an object of the present invention is to provide a light-emitting diode having a structure with which the heat generated by the light-emitting element can effectively escape to the outside and the operating performance of the light-emitting element can be maintained while retaining the mechanical strength of the leads and the molded member.

### SUMMARY OF THE INVENTION

The light-emitting diode of the present invention has a first lead with a cup part in which a light-emitting element is held, a second lead in juxtaposition with the first lead, and a resin molding enclosing the tips of the first and second leads. Flag-shaped protrusions are formed in the middle of the first and second leads. The region from the cup part of the first lead to the flag-shaped protrusion is relatively wide, and a concave part is formed along a side edge at a height near the bottom of the cup part of the first lead. This concave part reinforces the mechanical coupling strength of the lead and the resin molding.

A concave part can be formed not only in the edge of one side of the first lead, but also along both the edge of the side facing the second lead and the side facing toward the outside face. The bottom edge of at least the concave part of the side facing the second lead can be determined by the top edge of a protrusion laterally extending at the side, and at least parts of this bottom edge can serve as an edge that virtually faces up. In this case, the bottom edge of the protrusion should become an edge at least part of which virtually faces down. The concave part formed in the side facing the second lead should be positioned at the second lead side from the center of the cup part.

The flag-shaped protrusions of the first and second leads virtually contact the substrate when the light-emitting diode is mounted on a substrate. A notched end can be made in the position of the first lead in front of the flag-shaped protrusion of the second lead. The notched end can be an inclined edge inclined down away from the second lead.

A plate-shaped part positioned at the top of the first lead supporting a light-emitting element has a relatively wide top half that includes the cup part and the concave parts, and a relatively narrow bottom half that is overlapped by the bottom end of the resin molding and also includes the flag-shaped protrusion. The outside edges of the top half and the bottom half match. The bottom half can be shorter than the top half. The bottom half can also be wider than the hole insertion part at all positions beginning at the height of the flag-shaped protrusion and extending up to the top half.

By means of the light-emitting diode of the present invention, a path for effective heat transmission is formed from the semiconductor light-emitting element to the surface of the circuit board substrate on which the light-emitting diode is mounted; therefore, the heat generated by the semiconductor light-emitting element can effectively escape to the outside. Moreover, sufficient mechanical strength can be retained between the resin molding and the lead on which the light-emitting element is mounted. In addition, short-circuiting at the position of the flag-shaped protrusion can be prevented with certainty.

### BRIEF DESCRIPTION OF THE DRAWINGS

Fig. 1 is a rough sketch showing the structure of the light-emitting diode of the present invention.
Fig. 2 is a rough sketch showing the structure of a light-emitting diode of the prior art.

### DETAILED DESCRIPTION OF THE PREFERRED EMBODIMENT

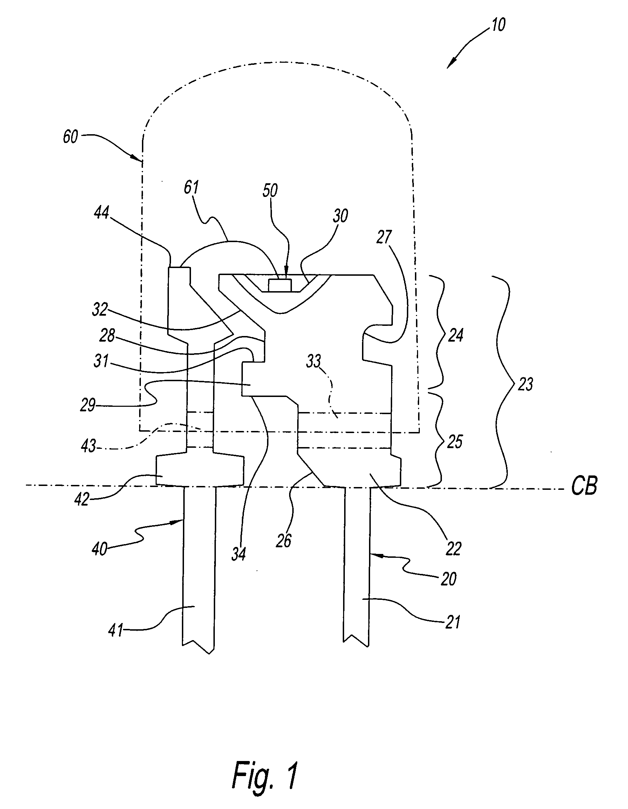

A preferred embodiment of the light-emitting diode of the present invention will now be described in detail while referring to the attached drawing. Figure 1 is a cross-section showing the inside structure of the light-emitting diode of the present invention.

As illustrated, a light-emitting diode 10 comprises a first metal lead 20 and a second metal lead 40, with a light-emitting element (or LED chip) 50 mounted on first lead 20. Light-emitting element 50 is held inside a cup part 30, which is a concave shape made in the top end of first lead 20 on which the light generated from light-emitting element 50 converges and is radiated up. Cup part 30 is formed such that part of the top end of first lead 20 made from a metal plate is pressed from the top and deformed to form a concave shape.

Light-emitting element 50 inside cup part 30 is electrically connected to first lead 20 with conductive material (conductive resin, etc.) and is electrically connected to second lead 40 by means of a bonding wire 61. The top end of second lead 40 protrudes slightly beyond the top end of first lead 20 and has a flat part 44 for connecting bonding wire 61.

First and second leads 20 and 40 have flag-shaped protrusions 22 and 42 in the middle, and long-thin hole insertion parts 21 and 41 extending down from these protrusions. When light-emitting diode 10 is inserted into a circuit board substrate, hole insertion parts 21 and 41 pass through the through-holes in the circuit board substrate.

Light-emitting diode 10 is electrically connected to a pattern on a circuit board substrate and at the same time, mechanically anchored to the circuit board substrate by being connected by soldering to the top surface or the bottom surface of the circuit board substrate with hole insertion parts 21 and 41 inserted into the through holes. Flag-shaped protrusions 22 and 42 virtually touch the surface of the circuit board substrate in this connected state. Flag-shaped protrusions 22 and 42 function as stoppers when hole insertion parts 21 and 41 are inserted into through holes in the circuit board substrate. The surface of the circuit board substrate in Figure 1 is hypothetically shown by broken line CB.

The tips of the first and second leads are protected by being enclosed in a resin molding 60. An epoxy material is an example of resin molding 60. Resin molding 60 is approximately the shape of a shell and the surface at the top end functions as a lens for converging light. As illustrated, light-emitting element 50 is near or at a position overlapping the center axis of resin molding 60.

Belt-shaped smooth surfaces 33 and 43 that have been subjected to a predetermined surface treatment such that the plate surface is smooth are placed in the middle of first and second leads 20 and 40. Smooth surfaces 33 and 43 intersect the base end surface of resin molding 60 to improve the adhesion between the metal surfaces of leads 20 and 40 and the resin material at the resin surface.

The light-emitting diode of the present invention is characterized in particular by the improved shape of first lead 20, which should improve the heat-radiating performance of the diode. It should be noted that, as illustrated, first lead 20 is made from a relatively wide plate-shaped part 23 starting from cup part 30 holding light-emitting element 50 to near flag-shaped protrusion 22 facing the circuit board substrate, forming an almost a linear heat conduction path.

Plate-shaped part 23 has a top half 24 near cup part 30 and a bottom half 25 that includes flag-shaped protrusion on this circuit board substrate side. Concave parts 27 and 28 are formed on either edge of first lead 20 at a height that is somewhat lower than the bottom end of cup part 30. Concave part 27 on the side nearest the outside surface of resin molding 60 approximately forms a rectangle. On the other hand, concave part 28 on the side facing second lead 40 includes an edge 31 demarcated by a rectangular protrusion 29 and virtually facing an inclined top edge 32 facing down. Protrusion 29 demarcates an edge 34 facing the bottom of lead 20.

The combination of concave parts 27 and 28 or concave part 27 and protrusion 29 has the effect of increasing the strength of the mechanical bond between first lead 20 and resin molding 60. Attention should be given to the fact that protrusion 29 protruding out will not break the path for heat conduction from cup part 30 to protrusion 22 that virtually contacts the circuit board substrate.

Bottom half 25 including smooth surface 33 is positioned outside relative to the position of hole insertion part 21 and is formed so that the outside edge matches top half 24. The region from the position of protrusion 22 (and an inclined edge 26 mentioned later) to top half 24 is a virtually constant width that is sufficiently wider than hole insertion part 21 and does not have a concave part, as illustrated. Moreover, bottom half 25 is made shorter than top half 24.

Protrusion 22 forms a shape that protrudes slightly from the edge. In contrast to this, the edge opposite protrusion 22, that is, the edge on the side facing flag-shaped protrusion 42 of second lead 40, becomes inclined edge 26 from which a protrusion has been cut out. Inclined edge 26 is made inclined down away from second lead 40. This is because it is necessary to maintain a sufficient distance between first and second leads 20 and 40 when they are connected by being soldered to the top surface of the circuit board substrate, so that the solder does not short-circuit protrusion 42 and first lead 20. Inclined edge 26 is farthest away from the second lead on the circuit board substrate side; therefore, solder is placed only near inclined edge 26 and is kept from spreading to the second lead 40 side.

As previously mentioned, plate-shaped part 23, which consists of top half 24 and bottom half 25, forms a heat conduction path that is relatively wide and extends linearly for the shortest distance from cup part 30 to flag-shaped protrusion 22. The heat that has been generated by operation of light-emitting element 50 is conducted through plate-shaped part 23 and effectively escapes to the metal pattern on the circuit board substrate. Consequently, stable operation of light-emitting element 50 is guaranteed.

A preferred embodiment of the light-emitting diode of the present invention has been described. However, this is given only as an example and in no way limits the present invention. Various other modifications and changes by persons skilled in the art are possible.

## Claims

1. A light-emitting diode comprising a first lead having a cup part for holding a light-emitting element, a second lead placed in juxtaposition with the first lead, and a resin molding for enclosing the tip parts of the first and second leads, wherein flag-shaped protrusions are formed at a common middle position in the first and second leads, wherein a region between the cup part of the first lead and the flag-shaped protrusion is wide and continuous and at least one concave part is formed along the side end of the first lead at a position of height near the bottom of said cup part.

2. The light-emitting diode according to claim 1, wherein said concave part is formed along each edge of both sides of the first lead that face the second lead and toward the outside face.

3. The light-emitting diode according to claim 1, wherein said concave part formed on the side facing the second lead is positioned at the second lead side from the center position of the cup part.

4. The light-emitting diode according to claim 1, wherein a bottom edge of the concave part on the side facing the second lead is determined by the top edge of the protrusion extending to the side to form an edge at least part of which virtually faces up.

5. The light-emitting diode according to claim 4, wherein a bottom edge of the protrusion becomes an edge at least part of which virtually faces down.

6. The light-emitting diode according to claim 1, when the light-emitting diode is mounted on a substrate, the flag-shaped protrusions of the first and second leads virtually touch this substrate, and a notched edge is made at a position in the first lead opposite the flag-shaped protrusion of the second lead.

7. The light-emitting diode according to claim 6, wherein said notched edge is formed from an inclined edge that is inclined down away from the second lead.

8. The light-emitting diode according to claim 1, wherein said first lead has a plate-shaped part overlapping the resin mold and a hole insertion part extending from this plate part; said plate-shaped part has a relatively wide top half part that includes the cup part and the concave part, and a relatively narrow bottom half part that includes the flag-shaped protrusion and intersects the bottom end of the resin molding; and the outside edges of the top half and the bottom half match.

9. The light-emitting diode according to claim 8, wherein said bottom half is shorter than said top half.

10. The light-emitting diode according to claim 8, wherein said bottom half is wider than the hole insertion part at all positions starting from the flag-protrusion part up to the top half.
